# FASCICULE DE BREVET EUROPEEN

(11) **EP 2 653 859 B1**
(45) Date de publication et mention de la délivrance du brevet: **16.08.2017**
(21) Numéro de dépôt: 13163332.3
(22) Date de dépôt: 11.04.2013
(51) Int. Cl.: G01R 27/20, G01R 31/00, G01R 31/02

(54) **Procédé de controle de la performance des jonctions électriques dans un réseau de retour de courant d'un aéronef**
Leistungskontrollverfahren von elektrischen Übergängen in einem Stromrückleitungsnetz eines Luftfahrzeugs
Method for monitoring the performance of electrical junctions in a current return network of an aircraft

(30) Priorité: 17.04.2012 FR 1253522
(43) Date de publication de la demande: 23.10.2013
(73) Titulaire: Airbus Operations (Société par actions simplifiée), 31060 Toulouse (FR)
(72) Inventeur: Landes, Olivier, 31240 SAINT-JEAN (FR)
(74) Mandataire: Augarde, Eric

(56) Documents cités:
- EP-A1- 2 385 382
- FR-A1- 2 602 874
- APRA M ET AL: "Lightning Indirect Effects Certification of a Transport Aircraft by Numerical Simulation", IEEE TRANSACTIONS ON ELECTROMAGNETIC COMPATIBILITY, IEEE SERVICE CENTER, NEW YORK, NY, US, vol. 50, no. 3, 1 août 2008 (2008-08-01), pages 513-523, XP011233361, ISSN: 0018-9375, DOI: 10.1109/TEMC.2008.927738

## Description

### DOMAINE TECHNIQUE

La présente invention concerne de manière générale le retour de courant pour les appareils électriques embarqués sur un aéronef comprenant des éléments en matériaux composites.

### ÉTAT DE LA TECHNIQUE ANTÉRIEURE

L'alimentation électrique des appareils électriques embarqués sur un aéronef est traditionnellement assurée par un câble d'alimentation en courant électrique et par un réseau de retour de courant réalisé par la structure de l'aéronef. Le réseau de retour de courant peut être assimilé au plan de masse général de l'aéronef.

Dans un appareil dont les éléments du fuselage et de la structure primaire (panneaux, cadres, lisses) sont réalisés en un matériau métallique, le retour de courant est réalisé par la présence de nombreuses pièces de structure interconnectées. Le nombre important d'interconnexions d'un bout à l'autre de l'appareil autorise un transport de courant sans difficulté.

La conception des avions récents fait appel aux matériaux composites, pour certaines parties de la structure externe ou interne de l'aéronef, afin d'alléger les aéronefs.

Les matériaux composites utilisés, comme le carbone ou des alliages de résines et de fibres, présentent une faible conductivité électrique et dès lors, ne peuvent être utilisés pour former un réseau de retour de courant. Le retour de courant est dans ce cas réalisé au moyen d'un réseau de structures métalliques de haute conductivité, dit réseau ESN (pour « Electrical Structural Network »), situé dans la zone pressurisée du fuselage et se composant majoritairement d'éléments métalliques structurels.

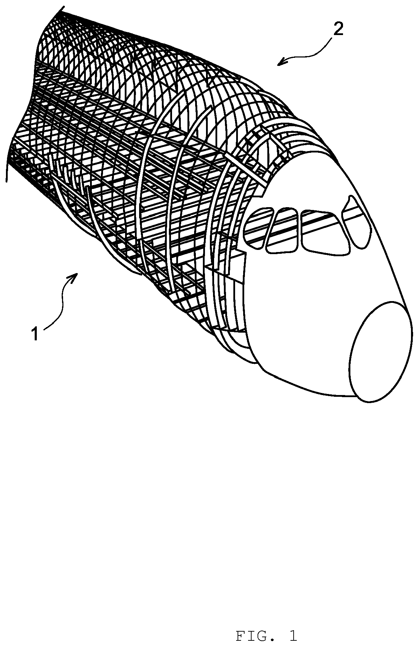

La figure 1 illustre une vue globale d'un réseau ESN 2 d'une partie d'un aéronef 1. La figure 1 montre plus particulièrement que le réseau ESN 2 d'un aéronef est un réseau maillé et redondé puisque chaque élément du réseau ESN est relié à au moins deux autres éléments du réseau. La redondance du réseau ESN est nécessaire pour respecter les normes de sécurité édictées par les instances de l'aviation civile.

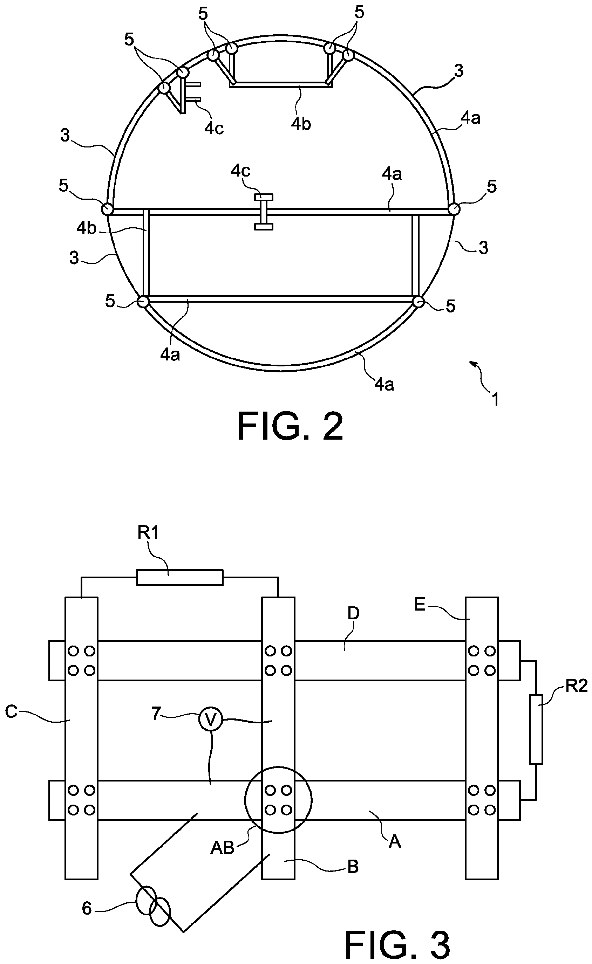

Plus précisément, le réseau ESN est constitué par des éléments métalliques structurels et des éléments métalliques de jonctions qui réalisent la continuité électrique entre les divers éléments structurels. La figure 2 illustre une section droite du fuselage d'un aéronef 1 comportant des éléments en matériaux composites 3 et un réseau ESN.

Les éléments structurels d'un réseau ESN sont de deux sortes :
- les éléments de structure primaire 4a de l'aéronef, par exemple les cadres métalliques, les traverses métalliques, les rails de sièges métalliques, le ou les planchers de l'aéronef ;
- les éléments de structure secondaire 4b de l'aéronef, qui comprennent des éléments transverses métalliques servant à soutenir des appareils électriques de l'aéronef, comme par exemple des calculateurs.

Les jonctions sont également de deux sortes :
- des jonctions électriques flexibles, du type « tresses métalliques », servant par exemple à réaliser certaines connexions entre les éléments primaires et secondaires du réseau ESN.
- des jonctions électromécaniques dont la fonction est à la fois mécanique mais également électrique. Il s'agit principalement de jonctions à base de rivets ou de vis et de boulons, entre deux éléments structurels du réseau ESN. Dans certains cas, une jonction électromécanique peut être renforcée par une jonction flexible.

Un réseau ESN comprend également des pièces standards 4c comme par exemple des composants métalliques en U ou en I, servant de supports pour les câbles électriques de l'aéronef. De tels supports sont appelés « raceways » en langage aéronautique. Les pièces standards sont reliées aux éléments de structure primaire ou secondaire du réseau par des jonctions électriques flexibles ou électromécaniques telles que définies ci-dessus.

Ainsi que l'illustre la figure 2, les divers éléments structurels du réseau ESN sont reliés électriquement, au niveau d'interfaces composite/métal 5, aux éléments en matériaux composites 3 qui forment une partie de la structure de l'aéronef.

La continuité électrique entre les différents éléments métalliques formant le réseau ESN n'est obtenue qu'à la suite d'une opération dite de métallisation, réalisée lors du cycle de production de l'aéronef.

En effet, une peinture de protection contre la corrosion recouvre généralement tous les éléments métalliques du réseau ESN. De façon évidente, cette peinture n'est pas conductrice. D'autre part, un mastic d'interposition est souvent présent au niveau des jonctions électromécaniques entre les différents éléments structurels du réseau ESN afin d'éviter les phénomènes d'usure de contact.

L'opération de métallisation consiste à décaper la peinture et, si besoin est, à enlever le mastic d'interposition d'une surface de contact, pour mettre à nu localement l'élément métallique 4a, 4b considéré.

De faibles quantités résiduelles de mastic ou de peinture au niveau d'une jonction entre deux éléments du réseau ESN, suffisent à dégrader la qualité du contact électrique et donc l'efficience du réseau ESN.

On comprend alors qu'il est nécessaire de réaliser un contrôle des jonctions entre les différents éléments du réseau ESN. Ce contrôle doit pouvoir être réalisé dans le cadre de l'assemblage du réseau ESN, de sa réparation ou lors des visites d'inspection de l'aéronef.

On considère qu'une jonction électrique du réseau ESN atteint un niveau de performance en conduction suffisant si celle-ci est capable de véhiculer pendant un temps assez long, c'est-à-dire au moins 60 secondes, le niveau de courant pour lequel elle est spécifiée, sans échauffement important ni dégradation de son impédance. Les jonctions électromécaniques ou flexibles d'un réseau de type ESN doivent pouvoir véhiculer un minimum de 50 A efficace à une fréquence de l'ordre de 400 Hz.

Les méthodes de mesures d'impédance traditionnellement utilisées en électronique, comme par exemple celles utilisant un milli-ohmmètre ou un générateur de courant associé à un voltmètre, ne sont pas adaptées au contrôle des jonctions entre deux éléments d'un réseau ESN car celui-ci est maillé et redondé.

La figure 3 illustre la mise en oeuvre de la méthode dite 4 fils, encore appelée méthode Kelvin, afin de mesurer l'impédance d'une jonction électromécanique AB du réseau ESN au moyen d'un générateur de courant 6 associé à un voltmètre 7. Pour des raisons évidentes de concision, le réseau ESN est représenté de manière schématique en figure 3 et seules des liaisons électromécaniques entre des éléments de structure primaire A,B,C,D,E du réseau sont illustrées. Les résistances R1 et R2 représentent les résistances dues aux interfaces entre le réseau ESN et les éléments composites de l'aéronef.

En appliquant cette méthode, le courant injecté par le générateur de courant 6, supérieur ou égal à 50 A, se répartit dans les différentes branches formées par les différents éléments A,B,C,D,E et les éléments composites de l'aéronef, au prorata des résistances de chacune d'entre elles.

Par conséquent, la méthode 4 fils ne permet pas de contrôler la performance de la jonction AB puisque son application fournit la mesure de l'impédance de la jonction AB en parallèle avec le reste du réseau et non de la jonction AB seule.

De plus, cette méthode ne permet pas de maîtriser le niveau de courant injecté dans le réseau ESN et sa mise en oeuvre peut endommager la structure composite particulièrement sensible au passage du courant, notamment lorsque le matériau composite utilisé est le carbone.

L'invention vise à fournir un procédé permettant de contrôler la performance d'une jonction électrique entre deux éléments métalliques d'un réseau ESN et dont la mise en oeuvre ne détériore pas la structure composite de l'avion.

### EXPOSÉ DE L'INVENTION

Cet objectif est atteint par un procédé de contrôle d'une jonction électrique entre un premier élément métallique et un second élément métallique d'un réseau de retour de courant d'un aéronef, ledit réseau comportant une pluralité d'éléments métalliques dont chacun est au moins connecté à deux autres éléments, ledit aéronef comprenant au moins un élément en matériau composite connecté audit réseau, ledit procédé comprenant les étapes suivantes :
a) injecter au moyen d'un transformateur de courant monté en abaisseur de tension, un courant alternatif dans ledit réseau au-travers d'un conducteur dont une première extrémité est connectée audit premier élément et dont une seconde extrémité est connectée audit second élément, ledit transformateur étant électro-magnétiquement couplé audit conducteur et étant dimensionné pour fournir un courant de valeur minimum à une charge d'impédance prédéterminée, dite impédance nominale ;
b) mesurer la valeur dudit courant circulant dans ledit conducteur; la jonction entre ledit premier élément métallique et ledit second élément métallique étant identifiée comme défectueuse lorsque la valeur dudit courant ainsi mesurée est inférieure à ladite valeur minimum.

Avantageusement, le procédé comprend les étapes supplémentaires suivantes :
c) mesurer la chute de tension entre ledit premier élément métallique et ledit second élément métallique ;
d) calculer la valeur de l'impédance de ladite jonction à partir de la valeur dudit courant mesurée à l'étape b) et de la chute de tension ainsi mesurée,
ladite jonction étant identifiée comme de bonne qualité lorsque la valeur de l'impédance calculée à l'étape (d) est inférieure ou égale à l'impédance nominale.

Le transformateur de courant comprend un tore qui entoure le conducteur, le bobinage primaire dudit transformateur étant relié à un générateur de courant alternatif et est enroulé autour du tore, le secondaire du transformateur étant constitué par le conducteur à l'intérieur du tore, ledit générateur de courant alternatif délivrant un courant de 1A à une fréquence comprise entre 100 Hz et 400 Hz, ledit transformateur étant dimensionné pour fournir un courant minimum de 50 A à ladite charge d'impédance nominale.

Dans une variante de mise en oeuvre du procédé selon l'invention, le conducteur peut être installé temporairement en parallèle de ladite jonction électrique entre ledit premier et ledit second éléments métalliques, le temps du contrôle.

### BRÈVE DESCRIPTION DES DESSINS

D'autres caractéristiques et avantages de l'invention apparaîtront à la lecture du mode de réalisation préférentiel de l'invention fait en référence aux figures jointes parmi lesquelles :
- la figure 1, déjà décrite, illustre une vue globale d'un réseau ESN dans une partie du fuselage d'un aéronef;
- la figure 2, déjà décrite, illustre une section droite du fuselage d'un aéronef comportant des éléments en matériaux composites et un réseau ESN ;
- la figure 3, déjà décrite, illustre la mise en oeuvre, dans un réseau ESN représenté de manière schématique, de la méthode dite 4 fils afin de mesurer l'impédance d'une jonction électromécanique du réseau ;
- la figure 4 illustre le positionnement des moyens permettant de mettre en oeuvre le procédé de contrôle d'une jonction selon l'invention ;
- la figure 5 illustre schématiquement un type de transformateur utilisé pour la mise en oeuvre du procédé selon l'invention.

### EXPOSÉ DÉTAILLÉ DE MODES DE RÉALISATION PARTICULIERS

L'idée à la base de l'invention est de contrôler la performance en conduction d'une jonction flexible ou électromécanique entre deux éléments du réseau ESN, en utilisant un transformateur de courant monté en abaisseur de tension pour injecter, le temps du contrôle, un courant alternatif de forte intensité dans un conducteur électrique mis en parallèle de la jonction à contrôler.

Comme cela sera décrit plus loin, la mise en parallèle du conducteur et de la jonction à contrôler permet d'obtenir l'impédance de la jonction seule, en utilisant des moyens de mesures traditionnels tels que des ampèremètres ou des voltmètres.

De plus, les propriétés intrinsèques du transformateur de courant, dimensionné pour une charge de faible impédance, permettent de maîtriser le niveau de courant injecté dans le réseau ESN et par conséquent de ne pas endommager les éléments composites de l'aéronef.

Selon l'invention, le conducteur électrique peut être extérieur au réseau ESN dans le sens où il est installé temporairement en parallèle à la jonction électromécanique ou flexible à tester, le temps du contrôle.

Comme cela a été vu en référence avec la figure 2, une jonction flexible reliant deux éléments peut être mise en parallèle à une autre jonction flexible ou électromécanique entre ces deux mêmes éléments afin d'augmenter la robustesse du réseau localement. Dans ce cas, on pourra éviter l'installation d'un conducteur extérieur au réseau ESN. En effet, le courant alternatif de forte intensité est alors directement injecté dans le réseau ESN au-travers de la jonction flexible mise en parallèle de la jonction flexible ou électromécanique à contrôler.

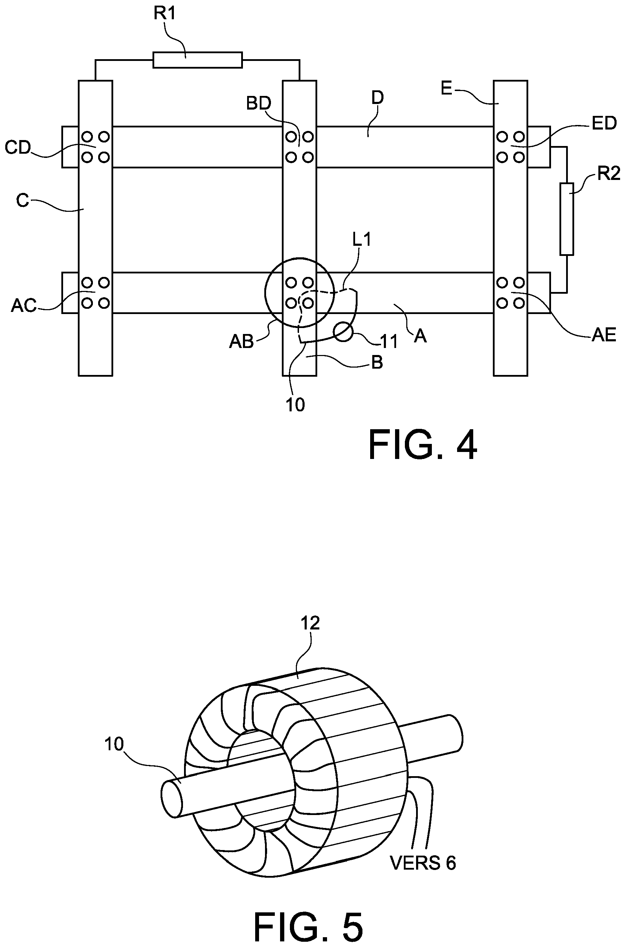

La figure 4 illustre le positionnement des moyens permettant de mettre en oeuvre le procédé de contrôle d'une jonction selon l'invention. Le réseau ESN représenté de manière simplifiée en figure 4, est identique à celui représenté en figure 3.

Plus précisément, la figure 4 illustre la mise en place du procédé de contrôle d'une jonction AB entre un élément métallique A et un élément métallique B du réseau ESN. La jonction électrique entre l'élément A et l'élément B est une jonction prise parmi la pluralité de jonctions AC,CD,BD,ED,AE existant entre les différents éléments métalliques A,B,C,D,E formant le réseau ESN de l'aéronef.

La jonction AB représentée en figure 4, est de type électromécanique simple. Par électromécanique simple, on entend que la jonction électromécanique n'est pas renforcée par une jonction flexible mise en parallèle. Il va de soi que la description du procédé qui va suivre, en relation avec la figure 4, serait identique pour une liaison flexible ou pour une liaison électromécanique renforcée par une jonction flexible mise en parallèle. Quelques spécificités propres à ces deux derniers cas de figures seront cependant brièvement décrites plus loin.

Afin de contrôler la performance en conduction de la jonction électrique AB, la première étape du procédé selon l'invention consiste à injecter un courant alternatif dans le réseau ESN au-travers d'un conducteur 10 mis en parallèle à la jonction AB. Plus précisément, la première extrémité du conducteur est connectée à l'élément A, et la seconde extrémité est connectée à l'élément B.

L'injection du courant se fait, par couplage électromagnétique, au moyen d'un transformateur 11 de courant positionné autour du conducteur 10.

Le conducteur 10 est avantageusement en cuivre ou en un matériau ayant une faible résistivité.

Avant la mise en place du conducteur, une opération locale de métallisation est préalablement effectuée sur une surface réduite de l'élément A ainsi que de l'élément B, là où les extrémités du conducteur 10 sont destinées à être connectées aux éléments A et B.

La figure 5 illustre le type de transformateur de courant 11 préférentiellement utilisé pour injecter un courant dans le conducteur 10. Le transformateur de courant 11 prend la forme d'un tore 12 qui entoure le conducteur 10. Le bobinage primaire, relié à un générateur de courant alternatif 6 (non représenté sur les figures 4 et 5), est enroulé autour du tore 12 tandis qu'au secondaire, la spire est constituée par le passage du conducteur 10 à l'intérieur du circuit magnétique torique. La fréquence du courant alternatif est inférieure ou égale à 400 Hertz, valeur de fréquence utilisée dans les aéronefs.

Revenant à la figure 4, on comprend que lorsqu'un courant est injecté dans le réseau ESN, une pluralité de boucles de courant (lignes de moindre impédance) passant par le conducteur et des éléments du réseau ESN sont formées. D'autres boucles peuvent être formées par le conducteur, des éléments du réseau ESN et des éléments en matériaux composites.

Ainsi, une première boucle L1 (représentée en pointillés sur la figure 4) est la ligne de moindre impédance qui passe par le conducteur 10, la portion de l'élément A comprise entre la première extrémité du conducteur et la jonction AB et la portion de l'élément B comprise entre la seconde extrémité du conducteur 10 et la jonction AB.

L'impédance de chacune des boucles se compose de manière classique, d'une partie réelle et d'une partie imaginaire.

La partie réelle de l'impédance d'une boucle est notamment fonction de la résistivité des matériaux et de la section des éléments qui la composent, ainsi que de la longueur de la boucle.

La partie imaginaire de l'impédance d'une boucle est fonction de sa surface et est proportionnelle à la fréquence du courant injecté dans le réseau au moyen du transformateur.

Pour des fréquences supérieures à 100 Hz, on considère que la partie réelle des boucles comportant uniquement des éléments métalliques est négligeable devant la partie imaginaire. En effet, les éléments métalliques du réseau ESN, le plus souvent réalisés en aluminium, ont une faible résistivité, de l'ordre de 26.10⁻⁹ Ω·m à 300K. Le procédé selon l'invention est avantageusement mis en oeuvre à des fréquences comprises entre 100 Hz et 400 Hz. Dès lors, on peut considérer, en approximation, que l'impédance des boucles comportant uniquement des éléments métalliques, ne dépend que de leur surface.

Lorsque la jonction AB à tester est de bonne qualité, la boucle L1 est la boucle de plus faible impédance puisqu'elle a la plus petite surface. On comprend que les autres boucles ont une impédance très supérieure à celle de la boucle L1.

Par exemple, pour une liaison électromécanique de bonne qualité entre deux éléments de cadre métallique du réseau ESN, on estime que l'impédance est de l'ordre de 1 milli-Ohm pour une fréquence comprise entre 100 Hz et 400 Hz. Les autres boucles de courant qui passent par les éléments métalliques du réseau ESN ont une impédance de l'ordre du, voire supérieure au, centième d'Ohm pour une même plage de fréquences.

Les boucles de courant qui passent par des éléments en matériaux composites ont quant à elles, une impédance de l'ordre du, voire supérieure au, dixième d'Ohm. En effet, ces boucles ont d'une part une surface importante et de plus, les résistances R1 et R2 à l'interface entre le réseau ESN et les éléments en matériaux composites ont des valeurs non négligeables, même à des fréquences supérieures à 100 Hz. D'autre part, la résistivité des éléments composites, comme le carbone, est très importante, de l'ordre de 30 000·10⁻⁹ Ω·m à 300K.

On peut donc considérer, au regard des impédances des différentes boucles, que la jonction AB véhicule la quasi-totalité du courant alternatif fourni par le transformateur 11, lorsque celle-ci est de bonne qualité.

Le transformateur 11 doit fournir à une charge située au secondaire, un courant minimum de 50A à une fréquence comprise entre 100 Hz et 400 Hz, à partir d'un courant au primaire de l'ordre de 1A. Le transformateur est dimensionné pour une charge dont l'impédance est égale à l'impédance que doit avoir la jonction AB lorsqu'elle est de bonne qualité.

Par commodité, l'impédance de la charge pour laquelle est dimensionné le transformateur 11, sera appelée l'impédance nominale dans la suite de la description.

Par conséquent, la tenue en charge du transformateur 11 est assurée pour des valeurs d'impédance sensiblement égales à l'impédance nominale.

Pour des valeurs nominales de l'ordre du milli-Ohm, voire du dixième de milli-Ohm, un transformateur de courant de taille réduite convient, notamment pour la mise en oeuvre du procédé selon l'invention dans des endroits peu accessibles de l'aéronef.

La seconde étape du procédé consiste à mesurer la valeur du courant circulant dans le conducteur 10. A cette fin, un capteur de courant classique de l'état de l'art, du type ampèremètre, est utilisé. En variante, la valeur du courant circulant dans le conducteur 10 peut être déduite de la mesure du courant au primaire du transformateur.

La deuxième étape du procédé représente un premier test de qualité de la jonction AB entre l'élément A et l'élément B. En effet, lorsque la jonction AB est de très mauvaise qualité, son impédance est élevée, de l'ordre du dixième d'Ohm ou plus. Par conséquent, le courant reboucle par les autres boucles d'impédance très supérieures à la valeur nominale attendue pour la jonction AB. Dans ce cas, il devient impossible d'injecter un niveau de courant supérieur ou égal à 50A au moyen du transformateur. En effet, le transformateur n'est pas dimensionné pour fournir un tel niveau de courant à des impédances très supérieures à la valeur nominale.

La mesure du courant circulant dans le conducteur donne ainsi une première indication grossière quant à la qualité de la jonction AB.

Le transformateur de taille réduite, en plus d'être facilement utilisable, offre l'avantage de protéger les éléments en matériaux composites présents dans certaines des boucles du réseau. En effet comme vu ci-dessus, le transformateur n'est pas capable d'injecter un fort niveau de courant dans le réseau ESN lorsque l'impédance de la charge est très supérieure à la valeur nominale, ce qui est le cas pour l'impédance des boucles passant par des éléments en matériaux composites. La mise en oeuvre du procédé selon l'invention ne détériore donc pas la structure composite de l'avion.

Si, lors de la deuxième étape du procédé, une valeur de courant au moins égale à 50 A est mesurée dans le conducteur 10, alors on estime que la quasi-totalité du courant est véhiculée par la boucle L1.

La suite du procédé consiste à affiner les mesures des grandeurs électriques caractéristiques de la jonction AB afin de vérifier que son impédance est inférieure ou égale à sa valeur nominale, afin de connaître sa performance en conduction. La valeur nominale de l'impédance représente un seuil d'impédance maximal admissible au-delà duquel la jonction AB est identifiée comme défaillante.

La troisième étape du procédé consiste à mesurer la chute de tension entre l'élément A et l'élément B.

Cette mesure est effectuée, par exemple, au moyen d'un voltmètre et de pointes de touche, positionnées sur des surfaces localement métallisées, de part et d'autre de la jonction AB.

La quatrième étape du procédé consiste à calculer la valeur de l'impédance de la jonction AB à partir de la valeur du courant mesurée lors de la deuxième étape et de la chute de tension mesurée lors de la troisième étape.

La valeur de l'impédance de la jonction AB ainsi calculée est comparée à sa valeur nominale, qui va dépendre du type de jonction testé ainsi que de son emplacement dans le réseau. La jonction est de bonne qualité lorsque la valeur d'impédance calculée ne dépasse pas la valeur nominale.

Avantageusement, la détermination de l'impédance nominale d'une jonction est effectuée en prenant en compte, sous forme d'une marge de tolérance, l'impédance ajoutée par le conducteur 10, les résistances aux interfaces entre le conducteur 10 et les éléments A et B, ainsi que le comportement non idéal du transformateur 11.

Lorsque la jonction à contrôler est une jonction électromécanique renforcée par une jonction flexible mise en parallèle, les étapes du procédé décrites ci-dessus sont identiques à quelques variantes de mise en oeuvre près.

En effet, dans ce cas, le conducteur utilisé est la jonction flexible mise en parallèle. Ainsi la jonction flexible peut être métallisée sur toute ou une partie de sa longueur afin de placer les appareils de mesures de l'intensité et de permettre un couplage magnétique correct avec le primaire du transformateur.

Le transformateur de courant est choisi parmi les modèles dont le tore peut se scinder en deux parties, ou parmi les modèles dont le tore est en forme d'anneau fendu, afin de le monter autour de la jonction flexible du réseau ESN.

Lorsque la jonction à contrôler est une jonction flexible entre deux éléments A et B du réseau ESN, alors celle-ci joue le rôle du conducteur. En effet, puisque le réseau est redondé, la jonction flexible à contrôler est contenue dans une boucle et le procédé selon l'invention peut alors être mis en oeuvre. Ce cas de figure offre la meilleure précision de mesure de l'impédance de la jonction à tester, car la totalité du courant est véhiculé par le conducteur.

La jonction flexible qui fait office de conducteur est métallisée sur toute ou une partie de sa longueur afin de placer les appareils de mesure de l'intensité et de permettre un couplage magnétique correct avec le primaire du transformateur.

Le transformateur de courant est choisi parmi les modèles dont le tore peut se scinder en deux parties afin de le monter autour de la jonction flexible du réseau ESN, ou parmi les modèles dont le tore est en forme d'anneau fendu.

A l'issue du procédé, les parties qui ont été métallisées pour sa mise en oeuvre sont repeintes avec une peinture aviation anti-corrosion.

Le procédé selon l'invention peut-être mis en oeuvre pour toutes les jonctions flexibles ou électromécaniques du réseau ESN. Le procédé peut être mis oeuvre aisément et rapidement dans toutes les parties de l'aéronef, dans le cadre de l'assemblage des jonctions de l'ESN, de leur réparation ou de la vérification de leur non vieillissement dans la durée de vie de l'avion.

La mise en oeuvre du procédé fait appel à des moyens disponibles à moindre coût dans le commerce.

## Revendications

1. Procédé de contrôle d'une jonction électrique (AB) entre un premier élément métallique (A) et un second élément métallique (B) d'un réseau de retour de courant d'un aéronef (1), ledit réseau comportant une pluralité d'éléments métalliques dont chacun est au moins connecté à deux autres éléments, ledit aéronef comprenant au moins un élément en matériau composite (3) connecté audit réseau, **caractérisé en ce que** ledit procédé comprend les étapes suivantes :
a) injecter au moyen d'un transformateur de courant (11) monté en abaisseur de tension, un courant alternatif dans ledit réseau au-travers d'un conducteur (10) dont une première extrémité est connectée audit premier élément et dont une seconde extrémité est connectée audit second élément, ledit transformateur étant électromagnétiquement couplé audit conducteur et étant dimensionné pour fournir un courant de valeur minimum à une charge d'impédance prédéterminée, dite impédance nominale ;
b) mesurer la valeur dudit courant circulant dans ledit conducteur; la jonction (AB) entre ledit premier élément métallique et ledit second élément métallique étant identifiée comme défectueuse lorsque la valeur dudit courant ainsi mesurée est inférieure à ladite valeur minimum.

2. Procédé de contrôle selon la revendication 1, comprenant en outre les étapes suivantes :
c) mesurer la chute de tension entre ledit premier élément métallique (A) et ledit second élément métallique (B) ;
d) calculer la valeur de l'impédance de ladite jonction (AB) à partir de la valeur dudit courant mesurée à l'étape b) et de la chute de tension ainsi mesurée,
ladite jonction étant identifiée comme de bonne qualité lorsque la valeur de l'impédance calculée à l'étape (d) est inférieure ou égale à l'impédance nominale.

3. Procédé de contrôle selon la revendication 1 ou 2, **caractérisé en ce que** ledit transformateur de courant (11) comprend un tore (12) qui entoure le conducteur (10), le bobinage primaire dudit transformateur étant relié à un générateur de courant alternatif (6) et est enroulé autour du tore, le secondaire du transformateur étant constitué par le conducteur à l'intérieur du tore, ledit générateur de courant alternatif délivrant un courant de 1A à une fréquence comprise entre 100 Hz et 400 Hz, ledit transformateur étant dimensionné pour fournir un courant minimum de 50 A à ladite charge d'impédance nominale.

4. Procédé de contrôle selon la revendication 1 ou 2, **caractérisé en ce que** ledit conducteur (10) est installé temporairement en parallèle de ladite jonction électrique (AB) entre lesdits premier et second éléments métalliques, le temps du contrôle.

## Patentansprüche

1. Verfahren zur Kontrolle einer elektrischen Verbindung (AB) zwischen einem ersten metallischen Element (A) und einem zweiten metallischen Element (B) eines Stromrückleitungsnetzes eines Luftfahrzeugs (1), wobei das Netz eine Vielzahl von metallischen Elementen aufweist, von denen jedes mindestens mit zwei anderen Elementen verbunden ist, wobei das Luftfahrzeug mindestens ein mit dem Netz verbundenes Element aus Verbundmaterial (3) enthält, **dadurch gekennzeichnet, dass** das Verfahren die folgenden Schritte enthält:
a) Einspeisen eines Wechselstroms in das Netz mittels eines als Spannungsabwärtswandler montierten Stromwandlers (11) über einen Leiter (10), von dem ein erstes Ende mit dem ersten Element und ein zweites Ende mit dem zweiten Element verbunden ist, wobei der Wandler elektromagnetisch mit dem Leiter gekoppelt und bemessen ist, um einen Strom mit einem Mindestwert an eine Last vorbestimmter Impedanz zu liefern, Nennimpedanz genannt;
b) Messen des Werts des im Leiter fließenden Stroms;
wobei die Verbindung (AB) zwischen dem ersten metallischen Element und dem zweiten metallische Element als fehlerhaft erkannt wird, wenn der so gemessene Wert des Stroms niedriger als der Mindestwert ist.

2. Kontrollverfahren nach Anspruch 1, das außerdem die folgenden Schritte enthält:
c) Messen des Spannungsabfalls zwischen dem ersten metallischen Element (A) und dem zweiten metallischen Element (B);
d) Berechnen des Werts der Impedanz des Verbindung (AB) ausgehend vom im Schritt b) gemessenen Wert des Stroms und vom so gemessenen Spannungsabfall,
wobei die Verbindung als einwandfrei erkannt wird, wenn der im Schritt (d) berechnete Wert der Impedanz niedriger als die oder gleich der Nennimpedanz ist.

3. Kontrollverfahren nach Anspruch 1 oder 2, **dadurch gekennzeichnet, dass** der Stromwandler (11) einen Ringkern (12) enthält, der den Leiter (10) umgibt, wobei die Primärwicklung des Wandlers mit einem Wechselstromgenerator (6) verbunden und um den Ringkern gewickelt ist, wobei die Sekundärseite des Wandlers aus dem Leiter im Inneren des Ringkerns besteht, wobei der Wechselstromgenerator einen Strom von 1A mit einer Frequenz zwischen 100 Hz und 400 Hz liefert, wobei der Wandler bemessen ist, um einen Mindeststrom von 50A an die Last mit Nennimpedanz zu liefern.

4. Kontrollverfahren nach Anspruch 1 oder 2, **dadurch gekennzeichnet, dass** der Leiter (10) während der Zeit der Kontrolle vorübergehend parallel zur elektrischen Verbindung (AB) zwischen dem ersten und dem zweiten metallischen Element installiert wird.

## Claims

1. Method of testing an electrical junction (AB) between a first metallic element (A) and a second metallic element (B) in an aircraft current return network (1), said network comprising a plurality of metallic elements, each of which is connected to at least two other elements, said aircraft comprising at least one element made of a composite material (3) connected to said network, **characterised in that** said method comprises the following steps:
a) use a current transformer (11) mounted in a voltage step-down to inject an alternating current into said network through a conductor (10) a first end of which is connected to said first element and a second end of which is connected to said second element, said transformer being electromagnetically coupled to said conductor and sized to supply a current with a minimum value to a load with a predetermined impedance called the nominal impedance;
b) measure the value of said current circulating in said conductor;
the junction (AB) between said first metallic element and said second metallic element being identified as defective when the value of said current thus measured is less than said minimum value.

2. Testing method according to claim 1, also comprising the following steps:
c) measure the voltage drop between said first metallic element (A) and said second metallic element (B);
d) calculate the value of the impedance of said junction (AB) starting from the value of said current measured in step b) and the voltage drop thus measured,
said junction being identified as being good quality when the value of the impedance calculated in step (d) is less than or equal to the nominal impedance.

3. Testing method according to claim 1 or 2, **characterised in that** said current transformer (11) comprises a torus (12) that surrounds the conductor (10), the primary winding of said transformer being connected to an alternating current generator (6) and is wound around the torus, the secondary of the transformer being formed by the conductor inside the torus, said alternating current generator supplying a current of 1A at a frequency of between 100 Hz and 400 Hz, said transformer being sized to supply a minimum current of 50 A to said nominal impedance load.

4. Testing method according to claim 1 or 2, **characterised in that** said conductor (10) is temporarily installed in parallel with said electrical junction (AB) between said first and said second metallic elements for the duration of the test.
